# EUROPÄISCHE PATENTSCHRIFT

(11) **EP 4 103 336 B1**
(45) Veröffentlichungstag und Bekanntmachung des Hinweises auf die Patenterteilung: **20.08.2025**
(21) Anmeldenummer: 21701468.7
(22) Anmeldetag: 20.01.2021
(51) Int. Cl.: B05C 11/10, B05B 12/14, B05B 15/55, B05B 15/58, B05C 5/02, B05B 1/16, H05K 3/28

(54) **SELBSTREINIGEND AUSGEBILDETE KUNSTSTOFFBESCHICHTUNGSVORRICHTUNG**
SELF-CLEANING PLASTICS COATING DEVICE
DISPOSITIF D'ENDUCTION DE PLASTIQUE AUTONETTOYANT

(30) Priorität: 10.02.2020 DE 102020201623; 17.11.2020 DE 102020214438
(43) Veröffentlichungstag der Anmeldung: 21.12.2022
(73) Patentinhaber: Robert Bosch GmbH, 70442 Stuttgart (DE)
(72) Erfinder: BAI, Mingquan, 70191 Stuttgart (DE); HEBACH, Andreas, 71638 Ludwigsburg (DE)
(86) Internationale Anmeldenummer: PCT/EP2021/051148
(87) Internationale Veröffentlichungsnummer: WO 2021/160389

(56) Entgegenhaltungen:
- EP-A2- 1 806 216
- WO-A1-2018/178813
- DE-A1- 10 047 567
- DE-A1- 102016 213 141
- US-A1- 2017 245 373

## Beschreibung

### Stand der Technik

Die Erfindung betrifft eine Kunststoffbeschichtungsvorrichtung zum Beschichten einer Leiterplatte. Die Vorrichtung weist einen statischen Mischer auf. Der Mischer weist eine erste Einlassöffnung für eine erste Kunststoffkomponente, und eine zweite Einlassöffnung für eine zweite Kunststoffkomponente auf. Der Mischer weist auch einen Mischerausgang für eine Komponentenmischung, umfassend beide Komponenten, insbesondere die erste Komponente und die zweite Komponente auf. Die Vorrichtung weist auch einen ersten Anschluss für einen Vorratsbehälter für die erste Komponente auf, welcher mit der ersten Einlassöffnung mittels einer ersten Zufuhrleitung verbunden ist. Die Vorrichtung weist auch einen zweiten Anschluss für einen Vorratsbehälter für die zweite Komponente auf, welcher mit der zweiten Einlassöffnung mittels einer zweiten Zufuhrleitung verbunden ist.

Die folgenden Dokumente illustrieren den diesbezüglichen Stand der Technik; DE 100 47 567 A1, US 2017/245373 A1, DE 10 2016 213141 A1, EP 1 806 216 A2 sowie WO 2018/178813 A1.

### Offenbarung der Erfindung

Erfindungsgemäß weist die Vorrichtung zwei Applikatoren, nämlich einen Applikator, und einen weiteren Applikator für die Komponentenmischung auf. Die Vorrichtung weist auch ein Wechselventil auf, welches ausgebildet ist, den Mischerausgang des Mischers wahlweise mit dem Applikator oder dem weiteren Applikator zu verbinden. Durch die Verwendung zweier Applikatoren vorzugsweise nacheinander in der gleichen Vorrichtung kann präzise und schnell in der gleichen Vorrichtung beschichtet werden, was einen deutlichen Kostenvorteil zur Folge hat.

Vorteilhaft weist die Vorrichtung der eingangs genannten Art ein in die zweite Zufuhrleitung für die zweite Komponente - insbesondere seriell - eingekoppeltes Umschaltventil auf. Das Umschaltventil ist ausgebildet, den sich zwischen dem Umschaltventil und dem Mischer, insbesondere der zweiten Einlassöffnung, erstreckenden Zufuhrleitungsabschnitt der zweiten Zufuhrleitung wahlweise mit dem Anschluss für den Vorratsbehälter für die zweite Komponente, oder mit einem Spülbehälter zu verbinden. Die Vorrichtung ist bevorzugt ausgebildet, den Mischer und den Zufuhrleitungsabschnitt mit der ersten Komponente zu spülen.

Vorteilhaft kann so der Mischer und die Zufuhrleitungen für mehrere Beschichtungsvorgänge verwendet werden. Vorteilhaft kann nämlich so durch den Spülvorgang kein Kunststoffgemisch, gebildet aus beiden Komponenten in dem Mischer oder in den Zufuhrleitungen verbleiben. Die Vorrichtung kann so vorteilhaft nach einem Gebrauch von dem Komponentengemisch, welches beim Verbleib in der Vorrichtung aushärtet, gereinigt werden. Vorteilhaft ist die Vorrichtung so selbstreinigend ausgebildet.

Der Mischer weist bevorzugt einen Behälter auf, der einen Hohlraum umschließt. In dem Behälter ist eine Mischwendel oder eine die Komponentenströmung beeinflussende Struktur angeordnet. Die Wendel oder die Struktur sind jeweils ausgebildet, die erste Komponente und die zweite Komponente - insbesondere durch Verwirbelung bildend - miteinander zu vermengen und so ein insbesondere homogenes Komponentengemisch, das die erste und die zweite Komponente umfasst, zu erzeugen.

In einer bevorzugten Ausführungsform ist das Umschaltventil ein insbesondere steuerbar ausgebildetes Drei-Wege-Ventil. Das Drei-Wege-Ventil ist bevorzugt ausgebildet, den Zufuhrleitungsabschnitt der zweiten Zufuhrleitung wahlweise mit dem Anschluss für den Vorratsbehälter, oder mit dem Spülbehälter zu verbinden. Vorteilhaft kann der Zufuhrleitungsabschnitt der zweiten Zufuhrleitung beim Spülen, insbesondere mit der ersten Kunststoffkomponente, welche ein MatrixMaterial für den Kunststoff bildet, in einer zum Mischbetrieb der Vorrichtung umgekehrten Durchflussrichtung gespült werden. Die Kunststoffkomponente, insbesondere die erste Kunststoffkomponente, wird so zum Spülen des Mischers, und des zweiten Zufuhrleitungsabschnitts verwendet. Vorteilhaft können so Bestandteile der Vorrichtung, welche mit dem Reaktionsgemisch, umfassend beide Kunststoffkomponenten, in Berührung kommen, nach Gebrauch mit der ersten Kunststoffkomponente gespült werden. Die zweite Kunststoffkomponente, welche bevorzugt einen Härter zum Vernetzen der ersten Kunststoffkomponente, oder zum Ausbilden eines Reaktionsgemisches zwischen der ersten Kunststoffkomponente und der zweiten Kunststoffkomponente aufweist, kann so aus der Vorrichtung, insbesondere dem Mischer, entfernt werden. Der Mischer kann so vorteilhaft nach einer Standzeit für weitere Beschichtungsprozesse zur Verfügung stehen, und muss nicht ausgetauscht werden.

In einer bevorzugten Ausführungsform weist die Vorrichtung eine in der ersten Zufuhrleitung angeordnete erste Pumpe für die erste Komponente, und eine mit der ersten Pumpe verbundene Steuereinheit auf. Die Steuereinheit ist ausgebildet, ein Steuersignal zum Umschalten des Umschaltventils zu erzeugen, und ein Steuersignal für die Pumpe für die erste Komponente zu erzeugen. So kann ein Spülen des Mischers - insbesondere in Abhängigkeit der Steuersignale - eingeleitet werden.

Vorteilhaft kann die Vorrichtung so zur Selbstreinigung ausgebildet sein.

In einer bevorzugten Ausführungsform weist die Vorrichtung ein Sperrventil auf, welches angeordnet und ausgebildet ist, die zwischen dem Umschaltventil und dem Spülbehälter angeordnete Abflussleitung zu versperren. Vorteilhaft kann so der Spülvorgang, welcher die Rückwärtsleitung entlang des Zufuhrleitungsabschnitts der zweiten Zufuhrleitung umfasst, mittels des Sperrventils gestoppt werden, bevor das Umschaltventil wieder in Flussrichtung zu dem Vorratsbehälter zurückgestellt wird.

In einer bevorzugten Ausführungsform weist die Vorrichtung eine zweite Pumpe auf, welche angeordnet und ausgebildet ist, die zweite Komponente von dem zweiten Anschluss in Richtung Umschaltventil und so auch zum Mischer zu befördern. Vorteilhaft kann so mittels der Pumpe ein sicherer Komponentenfluss der zweiten Komponente zur Ausbildung eines vorbestimmten Mischungsverhältnisses zwischen der ersten Komponente und der zweiten Komponente erzeugt werden.

In einer bevorzugten Ausführungsform weist die Vorrichtung einen Drucksensor auf, welcher angeordnet und ausgebildet ist, den Komponentendruck der ersten Komponente im Bereich der ersten Einlassöffnung des Mischers zu erfassen. Vorteilhaft kann so der Komponentendruck beim Spülen und beim Dispensen erfasst und gesteuert werden. Die Steuereinheit kann dazu bevorzugt ein Steuersignal an die erste Pumpe senden.

In einer bevorzugten Ausführungsform weist die Vorrichtung einen Drucksensor auf, welcher angeordnet und ausgebildet ist, den Komponentendruck der Komponentenmischung am Mischerausgang zu erfassen und ein Drucksignal zu erzeugen, das einen Ausgangsdruck der Komponentenmischung repräsentiert. Die Kunststoffbeschichtungsvorrichtung ist bevorzugt ausgebildet, den Komponentendruck während des Auftragens in Abhängigkeit des Drucksignals einzustellen. Weiter bevorzugt ist die Kunststoffbeschichtungsvorrichtung ausgebildet, den Komponentendruck am Mischerausgang durch Ansteuern von Komponentenpumpen für die Komponenten, insbesondere einer ersten Pumpe für die erste Komponente und einer zweiten Pumpe für die zweite Komponente, im Abhängigkeit des Drucksignals zu regeln. Vorteilhaft kann so ein Applikationsdruck konstant gehalten werden. Weiter vorteilhaft kann so eine präzise Dosierung des Komponentenmischungsauftrags erreicht werden.

Die Applikatoren sind jeweils ausgebildet, die Komponentenmischung auf ein Substrat, insbesondere eine Leiterplatte, aufzutragen, insbesondere mittels Düsenstrahls aufzutragen, mittels kontaktloser Dosierung, auch Jetten genannt, aufzutragen, mittels Dispensen aufzutragen oder aufzusprühen. Bevorzugt ist der weitere Applikator ausgebildet, die Komponentenmischung mit einem kleineren Sprühwinkel auf das Substrat aufzutragen, als der Applikator. Vorteilhaft kann die Vorrichtung so mittels des Wechselventils die Komponentenmischung, welche von dem Wechselventil von dem Mischerausgang des Mischers empfangen werden kann, wahlweise an den Applikator, oder an den weiteren Applikator leiten.

Erfindungsgemäß weist die Vorrichtung eine eingangsseitig mit dem ersten Anschluss wirkverbundene, und ausgangsseitig mit dem Wechselventil verbundene Spülleitung auf. Das Wechselventil ist ausgebildet, die Spülleitung insbesondere wahlweise mit dem Applikator, oder mit dem weiteren Applikator zu verbinden. Vorteilhaft kann so die Leitung zwischen dem Wechselventil und dem weiteren Applikator, und der weitere Applikator selbst beim Verwenden des Applikators mit der ersten Komponente gespült werden, und beim Verwenden des weiteren Applikators, bei dem die Komponentenmischung vom Mischerausgang über das Wechselventil, und die Leitung zum weiteren Applikator geleitet wird, die sich zwischen dem Wechselventil und dem Applikator erstreckende Zufuhrleitung mit der über die Spülleitung empfangenen ersten Komponente gespült werden. So kann während eines Benutzens des weiteren Applikators der Applikator mit der ersten Komponente gespült werden, oder - insbesondere nach einem Umschalten des Wechselventils - während eines Benutzens des Applikators der weitere Applikator und die zu diesem führende Leitung mit der ersten Komponente gespült werden.

In einer bevorzugten Ausführungsform ist das Wechselventil ein insbesondere totvolumenfreies Vier-Wege-Ventil. Vorteilhaft können so zwischen den Leitungsanschlüssen des Wechselventils zwei parallel zueinander geschaltete Durchflüsse erzeugt werden, wobei das Vier-Wege-Ventil ausgebildet ist, zwischen zwei zueinander verschiedenen Durchflussstellungen zu wechseln. Bevorzugt ist das Vier-Wege-Ventil ausgebildet, in einer ersten Durchflussstellung den Mischerausgang mit dem Applikator zu verbinden, während - insbesondere zeitgleich dazu - die Spülleitung mit dem weiteren Applikator verbunden ist. So kann der weitere Applikator während einer Benutzung des Applikators gespült werden. Das Vier-Wege-Ventil ist weiter ausgebildet, in einer zweiten Durchflussstellung den Mischerausgang mit dem weiteren Applikator zu verbinden, während - insbesondere zeitgleich dazu - die Spülleitung mit dem Applikator verbunden ist.

Vorteilhaft können so die während eines Anlagenbetriebs der Vorrichtung nicht benutzten Applikatoren - insbesondere mittels der ersten Komponente - gespült werden, sodass beim Spülen die Komponentenmischung, welche in der Spülleitung oder im nicht genutzten Applikator aushärten kann, aus der Spülleitung und dem nicht benutzten Applikator in reinigender Weise entfernt werden kann.

Die Erfindung betrifft auch ein Verfahren zum Reinigen einer Zwei-Komponenten-Kunststoffbeschichtungsvorrichtung, insbesondere mittels einer Vorrichtung der vorbeschriebenen Art. Bei dem Verfahren wird in einem ersten Schritt zum Spülen eines Mischers eine zweite Zufuhrleitung für eine zweite Komponente gesperrt, und der Mischer bis hin zu einem Mischerausgang, und ein mit dem Mischer verbundener Zufuhrleitungsabschnitt der zweiten Zufuhrleitung mit einer ersten Komponente gespült. Bevorzugt wird der Zufuhrleitungsabschnitt der zweiten Zufuhrleitung entgegengesetzt zur Flussrichtung der zweiten Komponente mit der ersten Komponente gespült. Vorteilhaft kann so in dem Zufuhrleitungsabschnitt die Komponentenmischung nicht aushärten, während die Kunststoffbeschichtungsvorrichtung nicht betrieben wird.

In einer bevorzugten Ausführungsform des Verfahrens kann zum Auftragen der Komponentenmischung zwischen zwei Applikatoren umgeschaltet werden. Weiter bevorzugt wird während des Auftragens mit einem Applikator der Applikatoren - insbesondere nach Umschalten auf den Applikator - der jeweils andere - insbesondere nicht zum Auftragen - benutzte Applikator mit der ersten Komponente gespült. Vorteilhaft kann so die Komponentenmischung nicht in der Zuleitung zu einem nicht benutzten Applikator, und im nicht benutzten Applikator selbst aushärten, während der jeweils andere Applikator beim Auftragen einen Durchfluss der Komponentenmischung erfährt.

Die Vorrichtung kann die zuvor beschriebene Spülleitung, und das mit der Spülleitung verbundene Wechselventil, insbesondere Vier-Wege-Ventil, unabhängig von dem zuvor beschriebenen Umschaltventil, insbesondere Drei-Wege-Ventil, aufweisen.

Die vorab beschriebenen Zufuhrleitungen und die Spülleitung sind jeweils bevorzugt zum Fluidführen, insbesondere zum Führen einer flüssigen Kunststoffkomponente ausgebildet.

Die Erfindung wird nun im Folgenden anhand von Figuren und weiteren Ausführungsbeispielen beschrieben. Weitere vorteilhafte Ausführungsformen ergeben sich aus einer Kombination der in den Figuren und in den abhängigen Ansprüchen beschriebenen Merkmale.

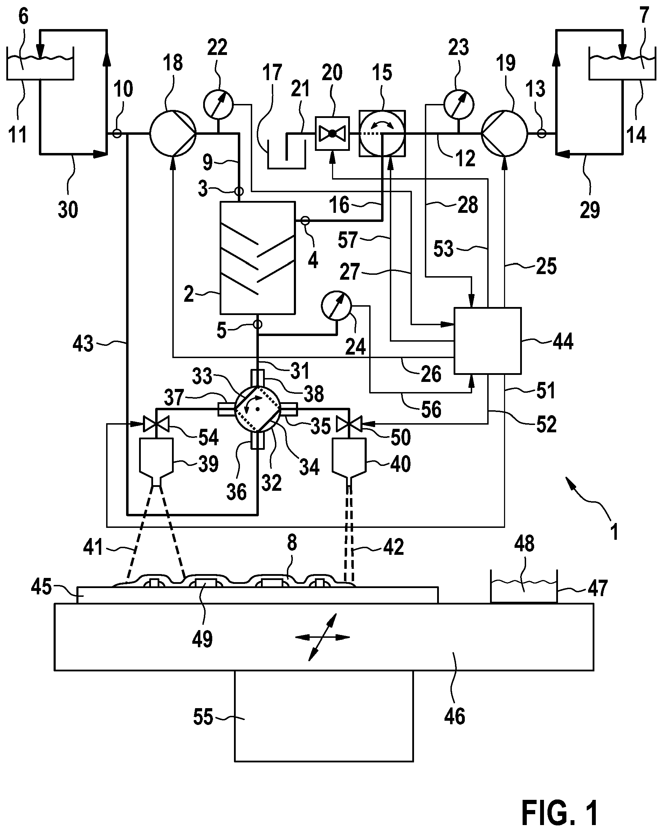

Figur 1 zeigt ein Ausführungsbeispiel für eine Kunststoffbeschichtungsvorrichtung, welche zum Beschichten eines Objekts, insbesondere einer Leiterplatte ausgebildet ist und welche zur Selbstreinigung ausgebildet ist.

Figur 1 zeigt ein Ausführungsbeispiel für eine Vorrichtung 1. Die Vorrichtung 1 ist als Kunststoffbeschichtungsvorrichtung zur Beschichtung von elektronischen Schaltungen ausgebildet. Die Vorrichtung 1 umfasst einen Mischer 2. Der Mischer 2 ist in diesem Ausführungsbeispiel als statischer Mischer zum Vermischen von zwei Kunststoffkomponenten ausgebildet. Der Mischer 2 weist einen Einlass 3 für eine erste Kunststoffkomponente 6 auf, und einen Einlass 4 für eine zweite Kunststoffkomponente 7 auf.

Der Mischer 2 ist ausgebildet, die an den Einlässen 3 und 4, insbesondere Einlassöffnungen, empfangenen Kunststoffkomponenten 6 und 7 aufzunehmen und miteinander während eines Durchfließens durch den Mischer 2 zu vermischen, und dabei eine Komponentenmischung umfassend die beiden Komponenten 6 und 7 zu erzeugen, in der die Komponenten 6 und 7 homogen verteilt sind. Der Mischer 2 ist ausgebildet, die Komponentenmischung ausgangsseitig an einem Mischerausgang 5 auszugeben. Der Mischer 2 weist in diesem Ausführungsbeispiel einen Behälter und eine in dem Behälter eingeschlossene Mischwendel auf. Der Behälter umschließt einen Hohlraum zum Vermischen der an den Einlässen 3 und 4 empfangenen Komponenten 6 und 7.

Die Vorrichtung 1 weist in diesem Ausführungsbeispiel eine Zufuhrleitung 9 für die erste Komponente 6 auf, welche einen Anschluss 10 zum Empfangen der ersten Komponente 6 mit dem Einlass 3 des Mischers 2 für die erste Komponente verbindet. In der Zufuhrleitung 9 ist in diesem Ausführungsbeispiel eine Komponentenpumpe 18 angeordnet, welche ausgebildet ist, die Komponente 6 an dem Anschluss 10 zu empfangen, und unter Erzeugung eines Drucks die Komponente 6 ausgangsseitig auszugeben, und die Komponente 6 mit einem Komponentendruck an dem Einlass 3 zum Gemischtwerden mit der zweiten Komponente 7 bereitzustellen.

Die Vorrichtung 1 umfasst auch eine Zufuhrleitung 12 für die zweite Komponente 7, welche mit einem Anschluss 13 für die zweite Komponente verbunden ist. Die Zufuhrleitung 12 mündet in diesem Ausführungsbeispiel in einen Anschluss eines Umschaltventils 15. Das Umschaltventil 15 ist ausgebildet, die Zufuhrleitung 12 mit einem Zufuhrleitungsabschnitt 16 für die zweite Komponente 7 zu verbinden. Der Zufuhrleitungsabschnitt 16 bildet einen Längsabschnitt der Zufuhrleitung 12, und mündet in den Einlass 4 des Mischers 2 für die zweite Komponente 7.

Die Komponente 6 ist in diesem Ausführungsbeispiel in einem Vorratsbehälter 11 aufgenommen, und die Komponente 7 ist in einem Vorratsbehälter 14 aufgenommen. Die Komponenten 6 und 7 sind jeweils in einem Komponentenkreislauf 30 beziehungsweise 29 in einer kontinuierlichen Flussbewegung gehalten. Der Kreislauf 30 für die erste Komponente 6 ist mit dem Anschluss 10 verbunden, und kann an dem Anschluss 10 die Komponente 6 bereitstellen. Der Kreislauf 29 für die zweite Komponente 7 ist mit dem Anschluss 13 für die zweite Komponente verbunden, und kann die Komponente 7 an dem Anschluss 13 bereitstellen.

Das Umschaltventil 15 ist in diesem Ausführungsbeispiel als Drei-Wege-Ventil ausgebildet, und ist ausgebildet, den Zufuhrleitungsabschnitt 16 wahlweise mit dem Anschluss 13, oder mit einer Abflussleitung 21 zu verbinden, welche in einen Spülrestbehälter 17 mündet. In der Abflussleitung 21 ist ein Sperrventil, insbesondere ein elektrisch schaltbares Sperrventil 20, angeordnet, welches ausgebildet ist, die Abflussleitung 21 in Abhängigkeit eines über eine Verbindungsleitung 53 empfangenen Steuersignals zu sperren oder freizugeben. Das Umschaltventil 15, insbesondere Drei-Wege-Ventil, ist ausgebildet, den Zufuhrleitungsabschnitt 16 in Abhängigkeit eines über eine Verbindungsleitung 57 empfangenen Steuersignals entweder mit dem Anschluss 13, oder mit der Abflussleitung 21, und so mit dem Restebehälter 17 zu verbinden. In der Zufuhrleitung 12 für die zweite Komponente ist in diesem Ausführungsbeispiel eine Pumpe 19 angeordnet, welche ausgebildet ist, die an dem Anschluss 13 empfangene zweite Komponente 7 zu empfangen, und unter Ausbildung eines Fluiddrucks die zweite Komponente über das Umschaltventil 15 mit dem Komponentendruck an dem Einlass 4 des Mischers 2 bereitzustellen. Die Vorrichtung 1 umfasst in diesem Ausführungsbeispiel auch einen Drucksensor 23, welcher mit der Zufuhrleitung 12 für die zweite Komponente verbunden und ausgebildet ist, einen in der Zufuhrleitung 12 herrschenden Fluiddruck der zweiten Komponente 7 zu erfassen und ein Drucksignal zu erzeugen, welches den Fluiddruck repräsentiert und das Drucksignal für die zweite Komponente über eine Verbindungsleitung 28 ausgangsseitig auszugeben. Die Vorrichtung 1 umfasst auch einen Drucksensor 22 zum Erfassen eines Fluiddrucks der ersten Komponente 6, welcher mit der Zufuhrleitung 9 für die erste Komponente verbunden und ausgebildet ist, den in der Zufuhrleitung 9, und so am Einlass 3 des Mischers 2, herrschenden Fluiddruck zu erfassen, und ein den Fluiddruck repräsentierendes Drucksignal zu erzeugen und dieses über eine Verbindungsleitung 27 ausgangsseitig auszugeben. Der von dem Drucksensor 23 erfasste Fluiddruck wird von der Pumpe 19 für die zweite Komponente 7 erzeugt. Der von dem Drucksensor 22 erfasste Fluiddruck wird von der Pumpe 18 für die erste Komponente 7 erzeugt.

Die Vorrichtung 1 umfasst in diesem Ausführungsbeispiel auch eine Verarbeitungseinheit 44, welche ausgebildet ist, Steuersignale zum Ansteuern der Pumpen 18, 19, und des Umschaltventils 15 in Abhängigkeit der von den Drucksensoren 22 und 23 erzeugten Drucksignale zu erzeugen. Die Verarbeitungseinheit 44 bildet in diesem Ausführungsbeispiel die vorab erwähnte Steuereinheit. Die Verarbeitungseinheit 44 ist auch ausgebildet, ein Sperrsignal zum Sperren des Sperrventils 20 zu erzeugen, und an das Sperrventil 20 zu senden. Ein Mischen der Komponenten 6 und 7 zum Erzeugen einer Komponentenmischung mittels des Mischers 2 kann beispielsweise wie folgt beschrieben erfolgen:

Die Verarbeitungseinheit 44 ist ausgebildet, ein Steuersignal zum Aktivieren der Pumpe 18 zu erzeugen und dieses über die Verbindungsleitung 26 an die Pumpe 18 zu senden. Die Verarbeitungseinheit 44 ist ausgebildet, ein Steuersignal zum Aktivieren der Pumpe 19 zu erzeugen und dieses über eine Verbindungsleitung 25 an die Pumpe 19 zu senden. Die Steuersignale repräsentieren jeweils einen von der Pumpe zu erzeugenden Komponentendruck. Die Verarbeitungseinheit 44 ist ausgebildet, die Steuersignale für die Pumpen 18 und 19 in Abhängigkeit eines von den Drucksensoren 22 beziehungsweise 23 empfangenen Drucksignals zu erzeugen. Auf diese Weise kann die Verarbeitungseinheit 44 den Komponentendruck, welcher von dem Pumpen 18 und 19 erzeugt, an den Einlassöffnungen 3 beziehungsweise 4 anliegt, regeln.

Die Verarbeitungseinheit 44 ist ausgebildet, zum Erzeugen der Komponentenmischung, umfassend die Komponenten 6 und 7, das Umschaltventil 15, insbesondere Drei-Wege-Ventil, derart einzustellen, dass der Anschluss 13 für die zweite Komponente 7 mit dem Einlass 4 für die zweite Komponente fluidgängig durchgehend verbunden ist. Die zweite Komponente kann so über den Einlass 4 in den Mischer 2 hineingelangen. Die erste Komponente 6 kann von dem Vorratsbehälter 11 über die Umlaufleitung 30 und über den Anschluss 10, weiter über die Pumpe 18, und die Zufuhrleitung 2 zu dem Einlass 3 für die erste Komponente 6 gelangen, und dort von der Pumpe 8 - gesteuert durch ein über die Verbindungsleitung 26 von der Verarbeitungseinheit 44 empfangenes Steuersignal - in den Mischer 2 hineingepumpt werden. Ein Mischungsverhältnis zwischen den Komponenten 6 und 7 kann dabei von der Verarbeitungseinheit in Abhängigkeit der von den Drucksensoren 22 und 23 jeweils erzeugten Drucksignale eingestellt werden. Die Pumpen 8 und 6 sind beispielsweise jeweils durch eine Verdrängerpumpe gebildet. Die Verdrängerpumpe weist beispielsweise eine Förderschnecke auf.

In einer anderen Ausführungsform kann das Mischungsverhältnis in Abhängigkeit eines Verhältnissens der Volumina der Pumpen zueinander vorbestimmt sein. Beispielsweise beträgt das Mischungsverhältnis aus der ersten Komponente und der zweiten Komponente zehn zu eins, so dass die Komponentenmischung die erste Komponente zehnmal so viel wie die zweite Komponente enthält.

Der Mischer 2 ist ausgebildet, die Komponenten 6 und 7 miteinander insbesondere durch Verwirbelung zu vermischen, und ein homogenes Komponentengemisch zu erzeugen und dieses ausgangsseitig an dem Mischerausgang 5 auszugeben.

Zum Spülen des Mischers 2 kann die Verarbeitungseinheit 44, welche beispielsweise durch einen Mikrocontroller oder einen Mikroprozessor gebildet ist, ein Steuersignal über die Verbindungsleitung 57 an das Umschaltventil 15 zum Stellen der fluidgängigen Verbindung zwischen dem Zufuhrleitungsabschnitt 16 und dem Spülbehälter 17 senden. Das Umschaltventil 15, insbesondere Drei-Wege-Ventil, ist ausgebildet, in Abhängigkeit des Stellsignals, erzeugt durch die Verarbeitungseinheit 44, den Fluidpfad von dem Einlass 4 für die zweite Komponente 7, und über den Zufuhrleitungsabschnitt 16 zu dem Spülbehälter 17 hin freizugeben. Die Verarbeitungseinheit 44 kann zur Freigabe der Leitung bis hin zu dem Spülbehälter 17 das Sperrventil 20 zu entsperren, und so den Fluidweg durch das Sperrventil 20 freigeben. Nach dem Umschalten des Umschaltventils 15 ist der Fluidweg von dem Einlass 4 für die zweite Komponente zu dem Anschluss 13 über die Zufuhrleitung 12 gesperrt. Die Verarbeitungseinheit 44 ist ausgebildet, zum Spülen des Mischers 2 ein Steuersignal zum Aktivieren der Pumpe 18 zu erzeugen, und so ausschließlich die erste Komponente 6 in den Mischer 2 einzubringen. Der durch die Pumpe 18 erzeugte Pumpendruck bewirkt so, dass die erste Komponente 6 in flüssiger Form zu dem Mischerausgang 5 hingedrückt wird, als auch durch den Einlass 4 für die zweite Komponente - in umgekehrter Richtung zur gewöhnlichen Flussrichtung der zweiten Komponente 7 - über das Umschaltventil 15, und das geöffnete Sperrventil 20 bis hin zu dem Spülbehälter 17.

Die in dem Zufuhrleitungsabschnitt 16 noch vorhandene Restmenge an zweiter Komponente 7, insbesondere ein Härter zum Aushärten der ersten Komponente 6, kann so aus der Zufuhrleitung und auch aus dem Mischer, insbesondere im Bereich des Einlasses 4, restlos ausgespült werden. Die Vorrichtung 1 ist dann mit der ersten Komponente 6 gespült, und bereit zum Stillstand. Die erste Komponente 6 ist ausgebildet, ohne Kontakt mit der zweiten Komponente 7, eine vorbestimmte Zeit in flüssigem Zustand in der Vorrichtung 1 und in den Zufuhrleitungen zu verbleiben. Der Mischer 2 kann so auch nach einem längeren Stillstand der Vorrichtung 1 zum nächsten Betrieb zum Erzeugen einer Komponentenmischung wiederverwendet werden und in der Vorrichtung 1 verbleiben.

Die Vorrichtung 1 weist zwei zueinander verschiedene Applikatoren 39 und 40 auf, welche jeweils ausgebildet sind, die von dem Mischer 2 erzeugte Komponentenmischung auf eine Leiterplatte 45 aufzutragen, insbesondere aufzujetten oder zu dispensen. Der Applikator 39 ist ausgebildet, einen breiten Fluidstrahl 41 zu erzeugen, und elektronische Bauelemente, von denen ein Bauelement 49 auf der Leiterplatte 45 beispielhaft bezeichnet ist, mit der Komponentenmischung 8 zu benetzen und so zu bedecken. Der weitere Applikator 40 ist ausgebildet, die Komponentenmischung mit einem schmalen Fluidstrahl 42 auf die Leiterplatte 45 aufzubringen, und so einen sauberen Rand einer durch die Komponentenmischung 8 gebildeten Komponentenmaske, oder eine örtlich begrenzte, inselförmige oder punktförmige Menge der Komponentenmischung auf den elektronischen Bauelementen der Leiterplatte 45 zu erzeugen. Auf diese Weise kann ein Bereich der Leiterplatte 45 frei von der Komponentenmischung bleiben, und nur ein vorbestimmter Bereich auf der Leiterplatte mit elektronischen Bauelementen von der Komponentenmischung 8 bedeckt, oder in die Komponentenmischung 8 eingebettet sein.

Die Vorrichtung 1 weist in diesem Ausführungsbeispiel ein Wechselventil 32 auf, welches ausgebildet ist, den Fluidweg von dem Mischerausgang 5 über die Auslassleitung 31 wahlweise entweder zu dem Applikator 39 zu stellen, oder zu dem weiteren Applikator 40 zu stellen. Während des Betriebs eines der Applikatoren 39 oder 40 ist der jeweils andere Applikator im Ruhebetrieb. Beim Ruhebetrieb befindet sich die ein Fluid in der Zufuhrleitung, welche sich zwischen dem Wechselventil 32 und dem Applikator erstreckt, im Stillstand. Die Vorrichtung 1 ist in diesem Ausführungsbeispiel vorteilhaft ausgebildet, während eines Betriebs eines der beiden Applikatoren 39 oder 40 die Zufuhrleitung zwischen dem Wechselventil 32 und dem jeweils nicht benutzten Applikator mit der ersten Komponente 6 zu spülen, und so von der Komponentenmischung zu reinigen. Auf diese Weise kann der jeweils nicht benutzte Applikator und die Zufuhrleitung dorthin nicht durch eine aushärtende Komponentenmischung während einer Zeit des Ruhebetriebs verstopft werden.

Das Wechselventil 32 ist dazu als Vier-Wege-Ventil ausgebildet. Das Wechselventil 32 weist dazu vier Anschlüsse 35, 36, 37 und 38 auf, wobei das Wechselventil ausgebildet ist, die Anschlüsse wechselseitig paarweise miteinander zu verbinden. In dem in Figur 1 dargestellten Ausführungsbeispiel der Vorrichtung 1 ist der Anschluss 38 mit dem Mischerausgang 5 über die Auslassleitung 31 fluidgängig verbunden. Der Anschluss 38 ist über einen einen Fluidpfad ausbildenden Kanal 33 in einem Stellglied des Wechselventils 32 mit dem Anschluss 37 fluidgängig verbunden. Zeitgleich dazu ist der Anschluss 35 des Wechselventils, welcher mit dem weiteren Applikator 40 über ein Sperrventil 50 verbunden ist, im geöffneten Zustand des Sperrventils 50 mit dem weiteren Applikator 40 fluidgängig verbunden. Der Anschluss 35 ist in der in Figur 1 gezeigten Stellung des Wechselventils 32 mit einem Anschluss 36 des Wechselventils 32 über einen weiteren Kanal 34 fluidgängig verbunden. Der Anschluss 36 ist mit einer Spülleitung 43 mit dem Anschluss 10 für die erste Komponente fluidgängig verbunden.

Auf diese Weise kann die erste Komponente 6 - mit einem in der Umlaufleitung 30 herrschenden Fluiddruck - durch das Wechselventil 32, und dort durch den mittels des weiteren Kanals 34 gebildeten Pfades, fluidgängig mit dem weiteren Applikator 40 verbunden werden. Der weitere Applikator und die Zufuhrleitung, welche sich zwischen dem Anschluss 35 und dem weiteren Applikator 40 erstreckt, kann so bei geöffnetem Sperrventil 50 mit der ersten Komponente gespült werden, während der Applikator 39 über den Kanal 33 die Komponentenmischung vom Mischerausgang 5 empfangen kann. In der Zufuhrleitung, welche sich zwischen dem Anschluss 37 und dem Applikator 39 erstreckt, ist ein Sperrventil 54 angeordnet, sodass der Applikator 39 ausgebildet ist, den Fluidstrahl 41 bei geöffnetem Sperrventil 54 zu erzeugen, oder bei geschlossenem Sperrventil 54 zu stoppen.

Das Sperrventil 50 kann Bestandteil des Applikators 40 sein. Das Sperrventil 54 kann Bestandteil des Applikators 39 sein.

Die Verarbeitungseinheit 44 ist über eine Verbindungsleitung 51 mit dem Sperrventil 54 verbunden und ist ausgebildet, ein Steuersignal zum Öffnen oder zum Schließen des Sperrventils 54 zu erzeugen und an das Sperrventil 54 zu senden. Die Verarbeitungseinheit 44 ist ausgebildet, über eine Verbindungsleitung 52 ein Steuersignal zum Öffnen oder Sperren des Sperrventils 50 zu erzeugen und an das Sperrventil 50 zu senden. Auf diese Weise kann die Verarbeitungseinheit 44 den Applikator 39, oder den Applikator 40 aktivieren oder deaktivieren. Das Wechselventil 32 kann, wie gepunktet dargestellt - insbesondere durch Drehen eines Stellelements um 90 Grad -, derart gestellt werden, dass der Mischerausgang 5 über den weiteren Kanal 34 mit dem Anschluss 35, und so der Fluidpfad von dem Mischerausgang 5 zu dem weiteren Applikator 40 hin freigeschaltet ist. Auf diese Weise kann der weitere Applikator 40 die Komponentenmischung mit einem schmalen Fluidstrahl 42 auf die Leiterplatte 45 zum Ausbilden einer Umrandung eines Bereiches auf der Leiterplatte 45 erzeugen.

In der Stellung des Wechselventils 32, in der der Fluidpfad von dem Mischerausgang bis zu dem weiteren Applikator 40 freigegeben ist, ist der Kanal 33 derart umgestellt worden, dass der Anschluss 36 von der Spülleitung 43, über den Kanal 33 mit dem Anschluss 37, und so mit dem Applikator 39 fluidgängig freigegeben ist. Während einer Benutzung des weiteren Applikators 40 kann somit die erste Komponente 6 als Spülfluid über die Spülleitung 43 die sich zwischen dem Wechselventil 32 und dem Applikator 39 erstreckende Fluidleitung, und den Applikator 39 selbst von der zuvor benutzten Komponentenmischung reinigen.

Die Vorrichtung 1 weist in diesem Ausführungsbeispiel auch einen Fahrtisch 46 auf, auf welchem die Leiterplatte 45 angeordnet ist. Auf dem Fahrtisch 46 ist auch ein weiterer Restebehälter 47 angeordnet, in dem ein Spülabfall 48, welcher beim Spülen der Applikatoren 39 beziehungsweise 40 ausgegeben werden kann, aufgefangen werden kann. Der Fahrtisch 46 ist in dieser Ausführungsform beispielsweise ausgebildet, in wenigstens zwei translatorischen Richtungen, in einer Ebene bewegt zu werden. Die Vorrichtung 1 kann dazu eine Stellvorrichtung 55 aufweisen, welche ausgebildet ist, den Fahrtisch 46 in zwei insbesondere orthogonal zueinander verlaufenden translatorischen Richtungen in einer Ebene zu bewegen. Auf diese Weise kann die Leiterplatte 45 unter dem Fluidstrahl 41, erzeugt durch den Applikator 39, oder den Fluidstrahl 42, erzeugt durch den weiteren Applikator 40, in der durch die translatorischen Richtungen aufgespannten Ebene bewegt werden, sodass auf der Leiterplatte 45 ein Flächenbereich mit der Komponentenmischung benetzt werden kann.

Die Stellvorrichtung 55 kann den weiteren Restebehälter 47 während des Spülens unter den jeweils zu spülenden Applikator fahren. Der weitere Restebehälter 47 kann in einer anderen Ausführungsform von einem weiteren - in Figur 1 nicht dargestellten - Fahrtisch in einer zu dem Fahrtisch 46 parallelen Ebene unter den zu spülenden Applikator gefahren werden, sodass die zwei Applikatoren gleichzeitig benutzt beziehungsweise gespült werden können. Die Sperrventile 50 beziehungsweise 54 können zum Spülen oder zum kurzzeitigen Anhalten des Beschichtungsvorgangs geöffnet, oder geschlossen werden.

Anders als in Figur 1 dargestellt, können die Applikatoren 39 und 40 jeweils mit einer Fahrvorrichtung verbunden sein, und von der Fahrvorrichtung in zwei translatorischen, oder drei zueinander orthogonal verlaufenden translatorischen Richtungen bewegt werden. Auf diese Weise kann beispielsweise die Leiterplatte 45 von dem Applikator 39 mit der Komponentenmischung benetzt werden, während - insbesondere zeitgleich dazu - der weitere Applikator von seiner eigenen, diesem zugeordneten Fahrvorrichtung über den weiteren Restebehälter 47 gefahren werden kann.

In einer vorteilhaften Ausführungsvariante ist die Fahrvorrichtung ausgebildet, die Applikatoren gemeinsam in einer Ebene translatorisch zu bewegen, wobei die Applikatoren jeweils unabhängig voneinander - insbesondere mittels eines Höhenverstellantriebs - höhenbeweglich oder höhenverstellbar ausgebildet sind.

Die Vorrichtung 1 kann so sowohl mittels des Umschaltventils 15, als auch mittels des Wechselventils 32 mit der ersten Komponente vollständig gespült und so von der Komponentenmischung vollständig gereinigt werden. Das Umschaltventil 15 und das Wechselventil 32 sind dazu in diesem Ausführungsbeispiel totvolumenfrei ausgebildet. Auf diese Weise können keine Komponentenmischungsreste beim Umschalten der Ventile in dem Ventil selbst verbleiben, und dort aushärten.

Die Vorrichtung 1 weist in diesem Ausführungsbeispiel auch einen Drucksensor 24 auf, welcher mit dem Mischerausgang 5 fluidgängig verbunden ist und so ausgebildet ist, einen an dem Mischerausgang 5 herrschenden Komponentendruck der Komponentenmischung zu erfassen, und ein Drucksignal zu erzeugen, welches den Komponentenmischungsdruck repräsentiert. Der Drucksensor 24 ist ausgebildet, das Drucksignal über eine Verbindungsleitung 56 an die Verarbeitungseinheit 44 zu senden. Die Verarbeitungseinheit 44 kann so den Druck der Komponentenmischung mittels entsprechender Steuersignale an die Pumpen 18 und 19 einstellen.

## Patentansprüche

1. Kunststoffbeschichtungsvorrichtung (1) zur Beschichtung einer Leiterplatte,
mit einem statischen Mischer (2), welcher eine erste Einlassöffnung (3) für eine erste Kunststoffkomponente (6) und eine zweite Einlassöffnung (4) für eine zweite Kunststoffkomponente (7) aufweist, und einen Mischerausgang (5) für eine Komponentenmischung (8) umfassend beide Komponenten (6, 7),
und die Kunststoffbeschichtungsvorrichtung (1) einen ersten Anschluss (10) für einen Vorratsbehälter (11) für die erste Komponente (6) aufweist, welcher mittels einer ersten Zufuhrleitung (9) mit der ersten Einlassöffnung (3) verbunden ist,
und die Kunststoffbeschichtungsvorrichtung (1) einen zweiten Anschluss (13) für einen Vorratsbehälter (14) für die zweite Komponente (7) aufweist, welcher mittels einer zweiten Zufuhrleitung (12) mit der zweiten Einlassöffnung (4) verbunden ist,
**dadurch gekennzeichnet, dass**
die Kunststoffbeschichtungsvorrichtung (1) zwei Applikatoren (39, 40), nämlich einen Applikator (39) und einen weiteren Applikator (40) für die Komponentenmischung (8) aufweist, und die Kunststoffbeschichtungsvorrichtung (1) ein Wechselventil (32) aufweist, welches ausgebildet ist, den Mischerausgang (5) des Mischers (2) wahlweise mit dem Applikator (39) oder dem weiteren Applikator (40) zu verbinden und die Kunststoffbeschichtungsvorrichtung (1) eine eingangsseitig mit dem ersten Anschluss (10) wirkverbundene und ausgangsseitig mit dem Wechselventil (32) verbundene Spülleitung (43) aufweist, wobei das Wechselventil (32) dazu ausgebildet ist, die Spülleitung (43) insbesondere wahlweise mit dem Applikator (39) oder mit dem weiteren Applikator (40) zu verbinden.

2. Kunststoffbeschichtungsvorrichtung (1) nach Anspruch 1,
**dadurch gekennzeichnet, dass**
die Kunststoffbeschichtungsvorrichtung (1) ein in die zweite Zufuhrleitung (12) für die zweite Komponente (7) eingekoppeltes Umschaltventil (15) aufweist, welches ausgebildet ist, den sich zwischen dem Umschaltventil (15) und dem Mischer (2), insbesondere der zweiten Einlassöffnung (4), erstreckenden Zufuhrleitungsabschnitt (16) der zweiten Zufuhrleitung (12) wahlweise mit dem Anschluss (13) für den Vorratsbehälter (14) für die zweite Komponente (7) oder mit einem Spülbehälter (17) zu verbinden, und die Kunststoffbeschichtungsvorrichtung (1) ausgebildet ist, den Mischer (2) und den Zufuhrleitungsabschnitt (16) mit der ersten Komponente (6) zu spülen.

3. Kunststoffbeschichtungsvorrichtung (1) nach Anspruch 2,
**dadurch gekennzeichnet, dass**
das Umschaltventil (15) ein insbesondere steuerbar ausgebildetes Dreiwegeventil ist.

4. Kunststoffbeschichtungsvorrichtung (1) nach einem der vorhergehenden Ansprüche 2-3,
**dadurch gekennzeichnet, dass**
die Kunststoffbeschichtungsvorrichtung (1) eine in der ersten Zufuhrleitung (9) angeordnete erste Pumpe (18) für die erste Komponente (6) und eine mit der ersten Pumpe (18) verbundene Steuereinheit (44) aufweist, welche ausgebildet ist, ein Steuersignal zum Umschalten des Umschaltventils (15) zu erzeugen und ein Steuersignal für die Pumpe (18) für die erste Komponente zu erzeugen, so dass ein Spülen des Mischers (2) eingeleitet werden kann.

5. Kunststoffbeschichtungsvorrichtung (1) nach einem der vorhergehenden Ansprüche 2-4,
**dadurch gekennzeichnet, dass**
die Vorrichtung ein Sperrventil (20) aufweist, welches angeordnet und ausgebildet ist, die zwischen dem Umschaltventil (15) und dem Spülbehälter (21) angeordnete Abflussleitung (21) zu versperren.

6. Kunststoffbeschichtungsvorrichtung (1) nach einem der vorhergehenden Ansprüche 2-5,
**dadurch gekennzeichnet, dass**
die Kunststoffbeschichtungsvorrichtung (1) eine zweite Pumpe (19) aufweist, welche angeordnet und ausgebildet ist, die zweite Komponente (7) von dem zweiten Anschluss (4) in Richtung Umschaltventil (15) und zum Mischer (2) zu befördern.

7. Kunststoffbeschichtungsvorrichtung (1) nach einem der vorhergehenden Ansprüche,
**dadurch gekennzeichnet, dass**
die Vorrichtung einen Drucksensor (22) aufweist, welcher angeordnet und ausgebildet ist, den Komponentendruck der ersten Komponente (6) im Bereich der ersten Einlassöffnung (3) des Mischers (2) zu erfassen.

8. Kunststoffbeschichtungsvorrichtung (1) nach einem der vorhergehenden Ansprüche,
**dadurch gekennzeichnet, dass**
die Vorrichtung einen Drucksensor (24) aufweist, welcher angeordnet und ausgebildet ist, den Komponentendruck der Komponentenmischung (8) am Mischerausgang (5) zu erfassen und ein Drucksignal zu erzeugen, das einen Ausgangsdruck der Komponentenmischung repräsentiert und die Kunststoffbeschichtungsvorrichtung (1) ausgebildet ist, den Komponentendruck (24) während des Auftragens in Abhängigkeit des Drucksignals einzustellen. dem Applikator (39) oder dem weiteren Applikator (40) zu verbinden.

9. Kunststoffbeschichtungsvorrichtung (1) nach einem der vorhergehenden Ansprüche,
**dadurch gekennzeichnet, dass**
das Wechselventil (32) ein insbesondere totvolumenfreies Vierwegeventil ist.

10. Verfahren zum Reinigen einer Zweikomponenten-Kunststoffbeschichtungsvorrichtung (1), nach einem der vorhergehenden Ansprüche,
**dadurch gekennzeichnet, dass**
die zum Spülen eines Mischers (2) eine zweite Zufuhrleitung (12) für eine zweite Komponente (7) gesperrt wird und der Mischer (2) bis hin zu einem Mischerausgang (5) und ein mit dem Mischer (2) verbundener Zufuhrleitungsabschnitt (16) der zweiten Zufuhrleitung (12) mit der ersten Komponente (6) gespült wird.

11. Verfahren nach Anspruch 10,
**dadurch gekennzeichnet, dass**
zum Auftragen der Komponentenmischung (8) zwischen zwei Applikatoren (39, 40) umgeschaltet werden kann und während des Auftragens mit einem Applikator (39, 40) der Applikatoren (39, 40) insbesondere nach Umschalten auf den Applikator (39, 40), der jeweils andere nicht zum Auftragen benutzte Applikator (39, 40) mit der ersten Komponente (6) gespült wird.

## Claims

1. Plastic coating device (1) for coating a printed circuit board, having a static mixer (2) which has a first inlet opening (3) for a first plastic component (6) and a second inlet opening (4) for a second plastic component (7) and has a mixer exit (5) for a component mixture (8) comprising both components (6, 7),
and the plastic coating device (1) has a first connection (10) for a storage container (11) for the first component (6), which is connected to the first inlet opening (3) by means of a first feed line (9),
and the plastic coating device (1) has a second connection (13) for a storage container (14) for the second component (7), which is connected to the second inlet opening (4) by means of a second feed line (12),
**characterized in that**
the plastic coating device (1) has two applicators (39, 40), specifically an applicator (39) and a further applicator (40) for the component mixture (8), and the plastic coating device (1) has a shuttle valve (32) which is configured to connect the mixer exit (5) of the mixer (2) selectively to the applicator (39) or to the further applicator (40), and the plastic coating device (1) has a flushing line (43) which is operatively connected at the entry side to the first connection (10) and is connected at the exit side to the shuttle valve (32), wherein the shuttle valve (32) is configured to connect the flushing line (43), in particular selectively, to the applicator (39) or to the further applicator (40).

2. Plastic coating device (1) according to Claim 1,
**characterized in that**
the plastic coating device (1) has a switching valve (15) which is coupled into the second feed line (12) for the second component (7) and which is configured to connect that feed-line portion (16) of the second feed line (12) which extends between the switching valve (15) and the mixer (2), in particular the second inlet opening (4), selectively to the connection (13) for the storage container (14) for the second component (7) or to a flushing container (17), and the plastic coating device (1) is configured to flush the mixer (2) and the feed-line portion (16) with the first component (6).

3. Plastic coating device (1) according to Claim 2,
**characterized in that**
the switching valve (15) is a three-way valve of in particular controllable design.

4. Plastic coating device (1) according to either of preceding Claims 2 and 3,
**characterized in that**
the plastic coating device (1) has a first pump (18), arranged in the first feed line (9), for the first component (6) and has a control unit (44) which is connected to the first pump (18) and which is configured to generate a control signal for switching the switching valve (15) and to generate a control signal for the pump (18) for the first component so that flushing of the mixer (2) can be initiated.

5. Plastic coating device (1) according to one of preceding Claims 2-4,
**characterized in that**
the device has a shut-off valve (20) which is arranged and configured to block the discharge line (21) which is arranged between the switching valve (15) and the flushing container (21).

6. Plastic coating device (1) according to one of preceding Claims 2-5,
**characterized in that**
the plastic coating device (1) has a second pump (19) which is arranged and configured to transport the second component (7) from the second connection (4) in the direction of the switching valve (15) and to the mixer (2).

7. Plastic coating device (1) according to one of the preceding claims,
**characterized in that**
the device has a pressure sensor (22) which is arranged and configured to detect the component pressure of the first component (6) in the region of the first inlet opening (3) of the mixer (2).

8. Plastic coating device (1) according to one of the preceding claims,
**characterized in that**
the device has a pressure sensor (24) which is arranged and configured to detect the component pressure of the component mixture (8) at the mixer exit (5) and to generate a pressure signal representing an exit pressure of the component mixture, and the plastic coating device (1) is configured to set the component pressure (24) during the application process according to the pressure signal.
to connect to the applicator (39) or to the further applicator (40).

9. Plastic coating device (1) according to one of the preceding claims,
**characterized in that**
the shuttle valve (32) is a four-way valve that is in particular free of dead volume.

10. Method for cleaning a two-component plastic coating device (1) according to one of the preceding claims,
**characterized in that**
for flushing a mixer (2), a second feed line (12) for a second component (7) is blocked and the mixer (2), as far as a mixer exit (5), and a feed-line portion (16) of the second feed line (12) that is connected to the mixer (2) are flushed with the first component (6).

11. Method according to Claim 10,
**characterized in that**
for application of the component mixture (8), switching between two applicators (39, 40) is possible and, during application by one applicator (39, 40) of the applicators (39, 40), in particular after switching to the applicator (39, 40), the in each case other applicator (39, 40) not used for the application is flushed with the first component (6).

## Revendications

1. Dispositif (1) de revêtement de matériau synthétique, destiné à revêtir un circuit imprimé, présentant un mélangeur statique (2), qui présente un premier orifice d'admission (3) pour un premier composant (6) de matériau synthétique et un second orifice d'admission (4) pour un second composant (7) de matériau synthétique et une sortie (5) de mélangeur pour un mélange (8) de composants comprenant les deux composants (6, 7),
et le dispositif (1) de revêtement de matériau synthétique présente un premier raccord (10) pour un réservoir (11) pour le premier composant (6), lequel réservoir est relié au moyen d'une première conduite d'alimentation (9) au premier orifice d'admission (3),
et le dispositif (1) de revêtement de matériau synthétique présente un second raccord (13) pour un réservoir (14) pour le second composant (7), lequel réservoir est relié au moyen d'une seconde conduite d'alimentation (12) au second orifice d'admission (4),
**caractérisé en ce que**
le dispositif (1) de revêtement de matériau synthétique présente deux applicateurs (39, 40), à savoir un applicateur (39) et un autre applicateur (40) pour le mélange (8) de composants et le dispositif (1) de revêtement de matériau synthétique présente une vanne à deux voies (32) qui est réalisée pour relier la sortie (5) du mélangeur (2) au choix avec l'applicateur (39) ou avec l'autre applicateur (40) et le dispositif (1) de revêtement de matériau synthétique présente une conduite de rinçage (43) reliée côté entrée fonctionnellement au premier raccord (10) et reliée côté sortie à la vanne à deux voies (32), la vanne à deux voies (32) étant réalisée pour relier la conduite de rinçage (43) en particulier au choix à l'applicateur (39) ou à l'autre applicateur (40).

2. Dispositif (1) de revêtement de matériau synthétique selon la revendication 1,
**caractérisé en ce que**
le dispositif (1) de revêtement de matériau synthétique présente une vanne de commutation (15) couplée dans la seconde conduite d'alimentation (12) pour le second composant (7), laquelle vanne est réalisée pour relier la section (16) de conduite d'alimentation, s'étendant entre la vanne de commutation (15) et le mélangeur (2), en particulier le second orifice d'admission (4), de la seconde conduite d'alimentation (12) au choix au raccord (13) pour le réservoir (14) pour le second composant (7) ou à un récipient de rinçage (17) et le dispositif (1) de revêtement de matériau synthétique est réalisé pour rincer le mélangeur (2) et la section (16) de conduite d'alimentation avec le premier composant (6).

3. Dispositif (1) de revêtement de matériau synthétique selon la revendication 2,
**caractérisé en ce que**
la vanne de commutation (15) est une voie à trois voies en particulier réalisée de manière commandable.

4. Dispositif (1) de revêtement de matériau synthétique selon l'une des revendications précédentes 2-3,
**caractérisé en ce que**
le dispositif (1) de revêtement de matériau synthétique présente une première pompe (18) pour le premier composant (6), agencée dans la première conduite d'alimentation (9) et une unité de commande (44) reliée à la première pompe (18), laquelle unité est réalisée pour générer un signal de commande pour la commutation de la vanne de commutation (15) et pour générer un signal de commande pour le pompe (18) pour le premier composant de telle sorte qu'un rinçage du mélangeur (2) peut être initié.

5. Dispositif (1) de revêtement de matériau synthétique selon l'une des revendications précédentes 2-4,
**caractérisé en ce que**
le dispositif présente une vanne d'arrêt (20) qui est agencée et réalisée pour bloquer la conduite d'évacuation (21) agencée entre la vanne de commutation (15) et le récipient de rinçage (21).

6. Dispositif (1) de revêtement de matériau synthétique selon l'une des revendications précédentes 2-5,
**caractérisé en ce que**
le dispositif (1) de revêtement de matériau synthétique présente une seconde pompe (19) qui est agencée et réalisée pour transporter le second composant (7) à partir du second raccord (4) en direction de la vanne de commutation (15) et vers le mélangeur (2).

7. Dispositif (1) de revêtement de matériau synthétique selon l'une des revendications précédentes,
**caractérisé en ce que**
le dispositif présente un capteur de pression (22) qui est agencé et réalisé pour détecter la pression du premier composant (6) dans la zone du premier orifice d'admission (3) du mélangeur (2).

8. Dispositif (1) de revêtement de matériau synthétique selon l'une des revendications précédentes,
**caractérisé en ce que**
le dispositif présente un capteur de pression (24) qui est agencé et réalisé pour détecter la pression des composants du mélange (8) de composants au niveau de la sortie (5) du mélangeur et pour générer une signal de pression qui représente une pression de sortie du mélange de composants et le dispositif (1) de revêtement de matériau synthétique est réalisé pour régler la pression (24) des composants en fonction du signal de pression pendant l'application.
relier l'applicateur (39) ou l'autre applicateur (40).

9. Dispositif (1) de revêtement de matériau synthétique selon l'une des revendications précédentes,
**caractérisé en ce que**
la vanne de commutation (32) est en particulier une vanne à quatre voies sans volume mort.

10. Procédé de nettoyage d'un dispositif (1) de revêtement de matériau synthétique à deux composants selon l'une des revendications précédentes,
**caractérisé en ce que**
pour le rinçage d'un mélangeur (2), une seconde conduite d'alimentation (12) pour un second composant (7) est bloquée et le mélangeur (2) est rincé jusqu'à une sortie (5) de mélangeur et une section (16) de conduite d'alimentation de la seconde conduite d'alimentation (12) reliée au mélangeur (2) est rincée avec le premier composant (6).

11. Procédé selon la revendication 10,
**caractérisé en ce que**
pour l'application du mélange (8) de composants entre deux applicateurs (39, 40), une commutation peut avoir lieu et pendant l'application à l'aide d'un applicateur (39, 40) parmi les applicateurs (39, 40), en particulier après la commutation sur l'applicateur (39, 40), l'autre applicateur (39, 40) respectif non utilisé pour l'application est rincé avec le premier composant (6).
